# EUROPÄISCHE PATENTSCHRIFT

(11) **EP 1 956 711 B1**
(45) Veröffentlichungstag und Bekanntmachung des Hinweises auf die Patenterteilung: **12.08.2009**
(21) Anmeldenummer: 08100837.7
(22) Anmeldetag: 23.01.2008
(51) Int. Cl.: H03K 17/74

(54) **Elektronische Schaltung für einen Hochfrequenzschalter**
Electronic circuitry for a high frequency switch
Circuit électronique pour un commutateur haute fréquence

(30) Priorität: 02.02.2007 DE 102007006100; 06.07.2007 EP 07111897; 20.12.2007 EP 07123765
(43) Veröffentlichungstag der Anmeldung: 13.08.2008
(73) Patentinhaber: Feig Electronic GmbH, 35781 Weilburg-Waldhausen (DE)
(72) Erfinder: Wennrich, Andreas, 65554 Limburg (DE)
(74) Vertreter: Knefel, Cordula

(56) Entgegenhaltungen:
- DE-A1- 10 305 361
- DE-A1-3102005 013 12
- US-A- 4 637 065
- US-A- 4 979 232

## Beschreibung

Die Erfindung betrifft eine elektronische Schaltung für einen Hochfrequenzschalter zum Öffnen eines Antennenschwingkreises eines RFID-Systems.

Die Erfindung bezieht sich auf einen Hochfrequenzschalter ab 1 Megahertz (MHz), der Leistungen von beispielsweise 15 Watt (W) bei Spannungen von 500 Volt (V) und Strömen von 2 Ampere (A) schalten kann.

Diese elektrischen Größen können zum Beispiel an den Antennen eines RFID-Systems auftreten, bei denen der Abstand zwischen den Transpondern und der Antenne des RFID-Systems eine Distanz von 0,5 Metern überschreitet.

Die Antenne eines RFID-Systems besteht gemäß dem Stand der Technik in der Regel aus mindestens einer Antennenschleife, die eine Induktivität darstellt, und einer Anpassschaltung, mit deren Hilfe die Antenne möglichst gut auf die Betriebsfrequenz des RFID-Systems abgestimmt werden kann, um einen hohen Strom und damit eine hohe magnetische Feldstärke zu erzielen.

Häufig werden RFID-Systeme gemäß dem Stand der Technik mit mehreren Antennen betrieben, wobei die Trägerfrequenz von beispielsweise 13,56 MHz von einer zu einer anderen Antenne umgeschaltet wird. Dies kann zum Beispiel mit so genannten Multiplexern erfolgen. Derartige Anwendungen von RFID-Systemen werden beispielsweise in der DE 100 56 176 C1 und EP 1 619 750 A1 beschrieben. Abhängig von der Bauart, Größe und Anordnung der einzelnen Antennen entsteht aufgrund elektromagnetischer Felder eine mehr oder weniger hohe elektromagnetische Kopplung zwischen den einzelnen Antennen, wobei die elektromagnetischen Felder der gerade aktiven Antenne in benachbarten, inaktiven Antennen einkoppeln. Diese Kopplung der aktiven und inaktiven Antennen bewirkt eine Veränderung der Resonanzfrequenz des Antennenschwingkreises der aktiven Antennen und hat Verlustleistungen zur Folge, durch die nicht mehr die volle Leistung der aktiven Antenne zur Kommunikation mit Transpondern zur Verfügung steht.

Eine effektive Art zur Vermeidung einer gegenseitigen Kopplung von Antennen eines RFID-Systems wird erreicht, indem die Antennenschleife und damit der Antennenschwingkreis der inaktiven Antennen durch einen Schalter geöffnet wird. Ein Hochfrequenzschalter zum Öffnen von inaktiven Antennen wird in der DE 10 2005 013 123 A1 beschrieben, wobei in der dort beschriebenen Schaltung die Spannung zum Öffnen des aus PIN-Dioden aufgebauten Hochfrequenzschalters aus der eingekoppelten Spannung einer benachbarten Antenne erzeugt wird.

Das der Erfindung zugrunde liegende technische Problem besteht darin, eine verbesserte Ausführungsform eines Hochfrequenzschalters und eine elektronische Schaltung für einen Hochfrequenzschalter anzugeben, mit dem ein Antennenschwingkreis eines RFID-Systems vollständig geöffnet werden kann und damit für die eingekoppelte Hochfrequenzspannung einen näherungsweise vollständig geöffneten Schalter darstellt.

Dieses technische Problem wird durch die elektronische Schaltung mit den Merkmalen des Anspruches 1 gelöst.

Die erfindungsgemäße elektronische Schaltung für einen Hochfrequenzschalter zum Öffnen eines Antennenschwingkreises eines RFID-Systems, wobei der Hochfrequenzschalter, der aus mindestens zwei PIN-Dioden aufgebaut ist, über Gleichspannungen geöffnet und geschlossen werden kann, zeichnet sich dadurch aus, dass
- eine Gleichrichterschaltung, die außerhalb des Antennenschwingkreises angeordnet ist, die Sperrspannung zum Öffnen des Hochfrequenzschalters aus der speisenden Hochfrequenzspannung erzeugt, wobei über wenigstens eine Verbindungsleitung aus der speisenden Hochfrequenzspannung die Spannung zur Speisung der Gleichrichterschaltung, die zur Erzeugung der Sperrspannung dient, abgreifbar ist und wobei der Abgriff der Gleichrichterschaltung gleichstrommäßig entkoppelt ist, und
- die Gleichrichterschaltung so ausgelegt ist, dass sie eine Sperrspannung erzeugt, deren Betrag mindestens dem Spitze-Spitze-Wert der zu schaltenden Hochfrequenzspannung entspricht, und
- die Sperrspannung über dieselbe elektrische Verbindungsleitung geführt wird, über die auch die speisende Hochfrequenzspannung und eine Schließspannung zum Schließen des Hochfrequenzschalters zur Antenne des RFID-Systems geführt wird, wobei die Einspeisung der Sperrspannung in die eletrische Verbindungsleitung hochohmig über einen widerstand erfolgt, welcher einen widerstandswert Zwischen 1 Kiloohm (1 kΩ) und 10 Kiloohm (10 kΩ) aufweist und
- zu den gleichstrommäßig in Reihe geschalteten PIN-Dioden jeweils ein Widerstand parallel geschaltet ist.

Unter dem Begriff Spitze-Spitze-Wert wird die Summe aus den Beträgen des Maximalwerts der positiven Halbwelle und dem Minimalwert der negativen Halbwelle der zu schaltenden Hochfrequenzspannung verstanden.

Ferner gewährleistet die Erfindung, dass die Spannungen zur Steuerung des Hochfrequenzschalters und die speisende Hochfrequenzspannung über dieselbe Verbindungsleitung geführt werden.

Erfindungsgemäß ist hierzu die Verwendung eines Hochfrequenzschalters aus PIN-Dioden vorgesehen, wobei die PIN-Dioden mit Hilfe einer negativen Gleichspannung gesperrt werden können, die im Folgenden als Sperrspannung bezeichnet wird. Der Betrag der Sperrspannung muss mindestens so hoch sein, wie der Spitze-Spitze-Wert der zu schaltenden Hochfrequenzspannung, wobei der Spitze-Spitze-Wert der zu schaltenden Hochfrequenzspannung durch die eingekoppelte Hochfrequenzspannung bestimmt wird, deren Spitze-Spitze-Wert den der speisenden Hochfrequenzspannung um ein mehrfaches übersteigen kann.

Um den Hochfrequenzschalter wieder zu schließen, wird eine weitere Gleichspannung, die im Folgenden als Schließspannung bezeichnet wird, benötigt, die gegenüber der Sperrspannung eine positive Gleichspannung ist, deren Betrag aber sehr viel geringer sein kann als die Sperrspannung. Die Schließspannung kann beispielsweise von einer Schreib-/Lesestation, einem Multiplexer oder von einer Antennenanpassschaltung erzeugt werden.

Die erfindungsgemäße Schaltung gewährleistet, dass eine ausreichend hohe Sperrspannung erzeugt wird, um die PIN-Dioden des Hochfrequenzschalters vollständig zu sperren, und die es ermöglicht, dass die Sperrspannung über dieselbe elektrische Verbindungsleitung zur Antenne geführt wird, über die auch die speisende Hochfrequenzspannung und die Schließspannung zur Antenne geführt wird.

Dazu wird die Sperrspannung mit Hilfe einer Gleichrichterschaltung aus der speisenden Hochfrequenzspannung erzeugt. Je nach Höhe der benötigten Sperrspannung kann die Gleichrichterschaltung auch als Spannungsverdopplungs- oder Spannungsvervielfachungsschaltung, wie beispielsweise als Villard-Schaltung ausgeführt sein. Die Höhe der benötigten Sperrspannung kann von mehreren Parametern abhängen, wie zum Beispiel der Kopplung zwischen einem aktiven Antennenschwingkreis und dem zu öffnenden Antennenschwingkreis oder der Dauer, für die der PIN-Diodenschalter geöffnet sein soll.

Die Einspeisung der speisenden Hochfrequenzspannung in die Gleichrichterschaltung erfolgt dabei außerhalb des Antennenschwingkreises, da an dieser Stelle nicht die hohen Spannungen wie am Hochfrequenzschalter selbst auftreten. Um die Schließspannung nicht mit der Gleichrichterschaltung zu belasten, wird die Einspeisung der Hochfrequenzspannung gleichspannungsmäßig entkoppelt, wozu zum Beispiel ein Kondensator verwendet wird. Da die Gleichrichterschaltung für die speisende Hochfrequenzspannung eine Last darstellt, ist sie hochohmiger gegenüber der angeschlossenen Antenne ausgeführt.

Damit die Sperrspannung an allen PIN-Dioden anliegt, ist es erfindungsgemäß vorgesehen, je einen hochohmigen Widerstand parallel zu jeder PIN-Diode zu schalten, über die sich die Sperrspannung auf alle PIN-Dioden aufteilt.

Erfindungsgemäß wird die von der Gleichrichterschaltung erzeugte Sperrspannung ebenfalls außerhalb des Antennenschwingkreises in die speisende Hochfrequenzspannung eingespeist. Hierbei ist es vorteilhaft, die Sperrspannung hochohmig anzukoppeln, damit wiederum die speisende Hochfrequenzspannung und die Schließspannung durch die Gleichrichterschaltung so wenig wie möglich belastet werden.

Damit der Hochfrequenzschalter auch für einen langen Zeitraum sicher im geöffneten Zustand verbleibt, wird die Sperrspannung in einer weiteren vorteilhaften Ausführungsform in einem Pufferkondensator mit einer sehr hohen Kapazität gepuffert. Der geöffnete Hochfrequenzschalter stellt dabei eine sehr hochohmige Lastimpedanz dar. Die hohe Kapazität in Verbindung mit der hochohmigen Lastimpedanz des Hochfrequenzschalters ergibt eine lange Entladezeit des Pufferkondensators. Die erforderliche Entladezeit hängt wie die Höhe der Sperrspannung von mehreren Parametern, wie zum Beispiel der Kopplung zwischen einem benachbarten aktiven Antennenschwingkreis und dem zu öffnenden Antennenschwingkreis oder der Dauer, für den der Hochfrequenzschalter geöffnet sein soll, ab. Sind die Schließspannung und die speisende Hochfrequenzspannung aktiviert, wird der Pufferkondensator geladen. Wird die Schließspannung und die speisende Hochfrequenzspannung abgeschaltet, wird der Pufferkondensator langsam entladen und stellt die Sperrspannung für den PIN-Diodenschalter zur Verfügung.

In einer weiteren vorteilhaften Ausführungsform wird eine Entkoppelschaltung angegeben, die verhindert, dass die unter Umständen hohe Sperrspannung andere, mit der erfindungsgemäßen Schaltung elektrisch verbundene Komponenten, wie zum Beispiel eine Schreib-/Lesestation oder einen Multiplexer, beeinträchtigen oder beschädigen kann.

In der Entkoppelschaltung wird die speisende Hochfrequenzspannung über einen Kondensator, der für die verwendete Hochfrequenz sehr niederohmig ist, geführt. Parallel zu dem Kondensator liegt eine Induktivität, die für die verwendete Hochfrequenz sehr hochohmig ist. In Reihe zu der Induktivität ist ein Schalter vorgesehen, der zum Beispiel ein Transistorschalter oder ein Optokoppler sein kann, und der durch das Anlegen der Schließspannung geschlossen wird. Liegt die Schließspannung nicht mehr an, öffnet sich der Schalter und wird damit sehr hochohmig für die Sperrspannung, so dass eine Entladung der Sperrspannung über die Entkoppelschaltung so gut wie ausgeschlossen wird.

Gemäß der Erfindung wird der Antennenschwingkreis aufgetrennt. Damit wird auch die Antennenschleife aufgetrennt.

Weitere Merkmale und Vorteile der Erfindung ergeben sich anhand der zugehörigen Zeichnung, in der mehrere Ausführungsbeispiele einer erfindungsgemäßen Schaltung nur beispielhaft dargestellt sind. In der Zeichnung zeigen:
- Fig.1: ein Blockschaltbild mit dem prinzipiellen Aufbau aus Hochfrequenzschalter, Sperrspannungserzeugung und Steuerspannung;
- Fig. 2: ein Blockschaltbild der Schaltung zum Erzeugen und Einspeisen der Sperrspannung;
- Fig. 3: ein Schaltbild des Hochfrequenzschalters mit zusätzlichen Widerständen;
- Fig. 4: ein Blockschaltbild mit Entkoppelschaltung.

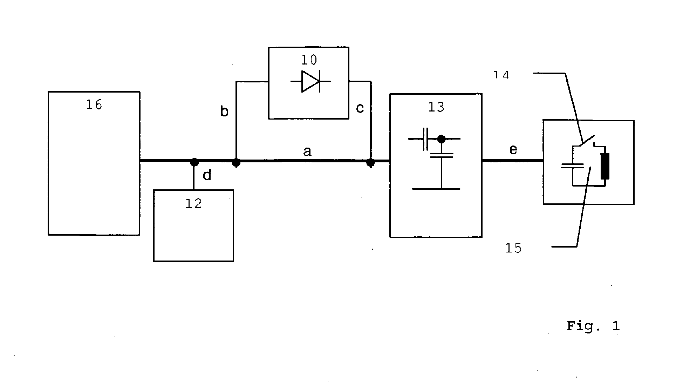

Fig. 1 zeigt einen prinzipiellen Aufbau einer Schaltungsanordnung bestehend aus einer Schreib-/Lesestation (16), einem Hochfrequenzschalter (14), der Bestandteil eines Schwingkreises (15) einer Antenne eines RFID-Systems ist, und einer Anpassschaltung (13) sowie einer Gleichrichterschaltung (10) zur Erzeugung der Sperrspannung und einer Vorrichtung zur Erzeugung der Schließspannung (12).

Um den Schwingkreis (15) mit dem Hochfrequenzschalter (14) zu schließen, wird die Schließspannung über eine Verbindungsleitung (d) auf eine Hochfrequenzverbindungsleitung (a) eingespeist.

Die Einspeisung der Hochfrequenzspannung zum Schwingkreis (15) erfolgt durch die Schreib-/Lesestation (16). Über eine Verbindungsleitung (b) wird aus der speisenden Hochfrequenzspannung die Spannung zur Speisung der Gleichrichterschaltung (10), die zur Erzeugung der Sperrspannung dient, abgegriffen. Die in die Gleichrichterschaltung (10) eingespeiste Hochfrequenzspannung wird dort durch eine Gleichrichterschaltung auf den benötigten Betrag zum Sperren des Hochfrequenzschalters (14) gebracht. Die Sperrspannung wird über eine Verbindungsleitung (c) eingespeist und über die Verbindungsleitungen (a) und (e) zum Hochfrequenzschalter (14) geleitet.

Die Steuerung, ob der Hochfrequenzschalter (14) geöffnet oder geschlossen werden soll, erfolgt über die Schließspannung, die über die Vorrichtung (12), die beispielsweise auch ein Bestandteil der Schreib-/Lesestation (16) sein kann, eingespeist wird. Sobald die Schließspannung abgeschaltet wird, wird der Hochfrequenzschalter (14) durch die in der Gleichrichterschaltung (10) erzeugte Sperrspannung geöffnet.

Die Induktivität in dem Antennenschwingkreis (15) ist die Antennenschleife.

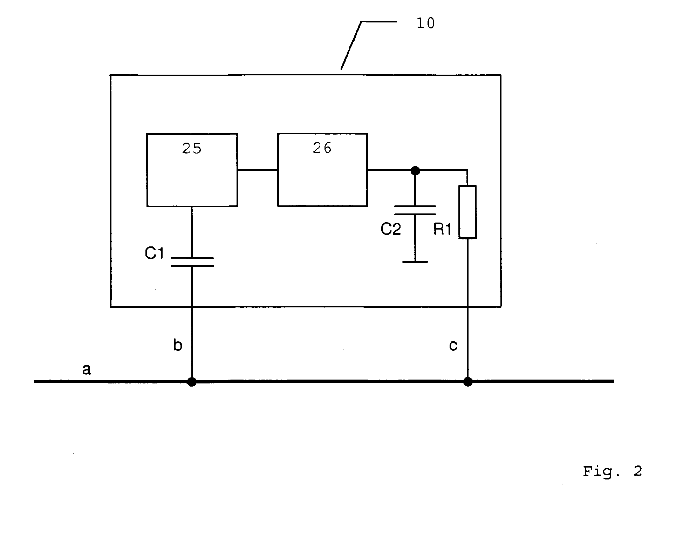

Fig. 2 zeigt eine Ausführungsform einer Gleichrichterschaltung (10) zur Erzeugung und Einspeisung der Sperrspannung, der die Hochfrequenzspannung über einem Koppelkondensator (C1), der für die Hochfrequenzspannung sehr niederohmig ist, zugeführt wird. Eine Gleichrichtung (26) ist über ein Bandfilter (25) mit dem Koppelkondensator (C1) verbunden. Das Bandfilter (25) verhindert das Aufmodulieren von Oberwellen auf die speisende Hochfrequenzspannung, die durch die Gleichrichtung (26) entstehen können.

Am Ausgang der Gleichrichtung (26), die je nach benötigter Höhe der Sperrspannung zum Beispiel als Einweggleichrichtung oder Villard-Schaltung ausgeführt sein kann, wird die erzeugte Sperrspannung mit einem Pufferkondensator (C2) mit hoher Kapazität gepuffert. Ein hochohmiger Lastwiderstand (R1) am Ausgang der Gleichrichtung (26) stabilisiert zusammen mit dem Pufferkondensator (C2) die Sperrspannung und verhindert durch seinen Widerstandswert, der in Relation zum Gleichstromwiderstand des geschlossenen Hochfrequenzschalters hoch ist, dass die Schließspannung durch den Ausgang der Gleichrichterschaltung (10) zu stark belastet wird.

Der Widerstand (R1) weist Werte zwischen 1 Kiloohm (1 kΩ) und 10 Kiloohm (10 kΩ) auf. Mit diesen Werten wird erreicht, dass die Sperrspannung genügend schnell über die Verbindungsleitung (c) in die Leitung (a) eingespeist werden kann. Es ist aber auch gewährleistet, dass die Gleichrichterschaltung (10) für die Schließspannung und die speisende Hochfrequenzspannung eine vernachlässigbare Belastung darstellt.

Die Kapazität (C2) weist vorteilhaft Werte zwischen 1 Mikrofarad (1 µF) und 10 Mikrofarad (10 µF) auf.

Bei der Dimensionierung der Kapazität sind folgende Faktoren zu berücksichtigen:
a) Der Ladevorgang soll schnell (beispielsweise innerhalb 50 Millisekunden (ms)) möglich sein.
b) Es soll für eine ausreichend lange Dauer (zum Beispiel eine Sekunde (1 s)) eine ausreichend hohe Sperrspannung zur Verfügung stehen. Die Zeitkonstante der Entladung wird bestimmt durch die Kapazität (C2) und die Widerstände (R3, R4).

Mit den angegebenen Zeiten kann zum Beispiel eine Antennenanordnung eines RFID-Systems mit acht relativ dicht beieinander angeordneten Antennen, die über einen Multiplexer angesteuert werden und zwischen denen jeweils eine mehr oder weniger hohe aber ungewollte Kopplung besteht, betrieben werden.

Die Dimensionierung der Kapazität (C2) und der Widerstände (R3, R4) hängt also jeweils stark davon ab, wie hoch und wie lange eine gewisse Höhe der Sperrspannung verfügbar sein soll. Die Höhe der benötigten Sperrspannung hängt jedoch von der Kopplung zwischen einer über den Schalter (14) abgeschalteten Antenne und einer benachbarten aktiven Antenne ab und ist damit extrem abhängig von der jeweiligen Anwendung des Schalters.

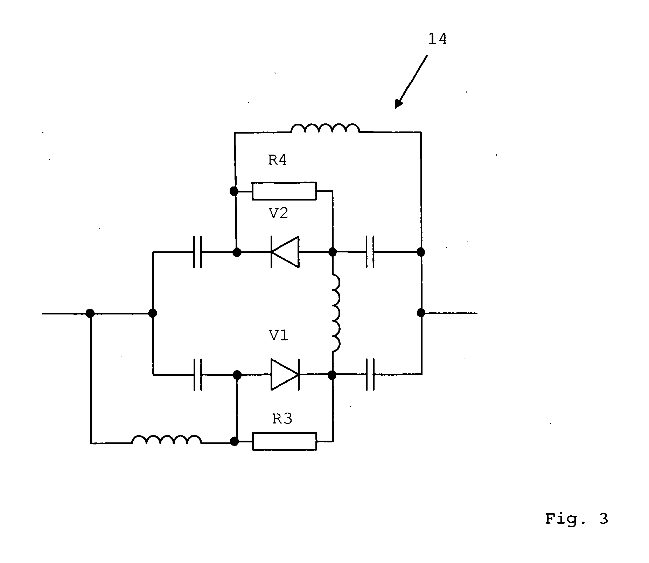

Fig. 3 zeigt den Aufbau des Hochfrequenzschalters (14) mit zwei PIN-Dioden (V1, V2). Dabei sind gleichgroße, hochohmige Widerstände (R3, R4) jeweils parallel zu den gleichstrommäßig in Reihe geschalteten PIN-Dioden (V1, V2) geschaltet. Die Sperrspannung teilt sich dadurch auf beide PIN-Dioden (V1, V2) gleichmäßig auf, so dass beide gesperrt werden können.

Gemäß einer vorteilhaften Ausführungsform der Erfindung ist der Widerstand (R3, R4) als hochohmiger Widerstand ausgebildet. Die Werte des Widerstandes (R3, R4) liegen vorteilhaft zwischen 1 Megaohm (1 MΩ) und 10 Megaohm (10 MΩ). Diese im Vergleich zu dem Widerstand (R1) um den tausendfachen Wert höheren Widerstandswerte sind in der Praxis notwendig, damit die im Pufferkondensator (C2) gespeicherte Ladung nur langsam über die Widerstände (R3 und R4) abfließen kann und die Gleichrichterschaltung (10) den Schalter (14) damit für eine möglichst lange Zeit geöffnet halten kann. Ein weiterer Grund für das Verhältnis der Widerstände (R1 zu R3 und R4) begründet sich darin, dass die Widerstände (R1, R3 und R4) eine gleichstrommäßige Reihenschaltung darstellen und ein möglichst hoher Anteil der Sperrspannung über den Widerständen (R3 und R4) abfallen soll.

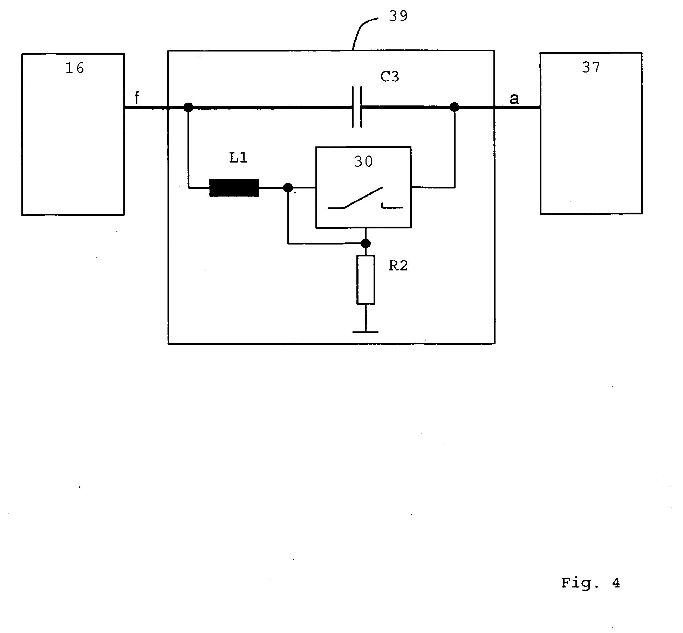

Fig. 4 zeigt ein Blockschaltbild einer Ausführungsform der Erfindung, bei der durch Einsatz einer Entkoppelschaltung (39) eine Rückwirkung der Sperrspannung auf die beispielhaft dargestellte Schreib-/Lesestation (16) verhindert wird, die es aber erlaubt, die Schließspannung von der Schreib-/Lesestation (16) zu einer Antennenbaugruppe (37) über dieselbe Leitung (a, f) zu führen, über die auch die die Antenne speisende Hochfrequenzspannung geleitet wird. Gleichzeitig gewährleistet die Schaltung, dass die gleichstrommäßige Verbindung zwischen Schreib-/Lesestation (16) und Antennenbaugruppe (37) automatisch getrennt wird, sobald keine Schließspannung mehr von der Schreib-/Lesestation (16) anliegt. Die Antennenbaugruppe (37) beinhaltet in diesem Fall die Komponenten Gleichrichterschaltung (10), Anpassschaltung (13), Hochfrequenzschalter (14) und Schwingkreis (15).

Die Entkoppelschaltung (39) besteht in diesem Ausführungsbeispiel aus einem Schalter (30), der zum Beispiel als Transistorschalter oder Optokoppler ausgeführt sein kann, einem Kondensator (C3), einer Induktivität (Spule) (L1) und einem Widerstand (R1). Liegt eine Schließspannung über eine Verbindungsleitung (f) an, so wird der Schalter (30) geschlossen, so dass die Gleichspannung an die Verbindungsleitung (a) gelangen kann. Wird die Schließspannung abgeschaltet, so öffnet der Schalter (30) die gleichstrommäßige Verbindung und die hohe Sperrspannung, die über die Verbindungsleitung (a) an der Entkoppelschaltung (39) anliegt, wird von dem weiteren Gerät getrennt. Der Kondensator (C3) stellt die hochfrequenzspannungsmäßige Verbindung dar, während die Induktivität (L1) gewährleistet, dass die Hochfrequenzspannung nicht über den Widerstand (R2) belastet wird. Der Widerstand (R2) ist so hochohmig, dass er ebenfalls die Schließspannung so wenig wie möglich belastet.

### Bezugszahlen

- 10: Gleichrichterschaltung
- 12: Vorrichtung zur Erzeugung einer Schließspannung
- 13: Anpassschaltung
- 14: Hochfrequenzschalter
- 15: Schwingkreis
- 16: Schreib-/Lesestation
- 25: Filterschaltung
- 26: Gleichrichtung
- 30: Schalter
- 37: Antennenbaugruppe
- 39: Entkoppelschaltung
- a: Verbindungsleitung
- b: Verbindungsleitung
- c: Verbindungsleitung
- d: Verbindungsleitung
- e: Verbindungsleitung
- f: Verbindungsleitung
- C1: Kondensator
- C2: Kondensator
- C3: Kondensator
- R1: Widerstand
- R2: Widerstand
- R3: Widerstand
- R4: Widerstand
- L1: Spule
- V1: PIN-Diode
- V2: PIN-Diode

## Patentansprüche

1. Elektronische Schaltung für einen Hochfrequenzschalter zum Öffnen eines Antennenschwingkreises eines RFID-Systems, wobei der Hochfrequenzschalter, der aus mindestens zwei PIN-Dioden aufgebaut ist, über Gleichspannungen geöffnet und geschlossen werden kann,
**dadurch gekennzeichnet, dass**
- eine Gleichrichterschaltung (10), die außerhalb des Antennenschwingkreises angeordnet ist, die Sperrspannung zum Öffnen des Hochfrequenzschalters (14) aus der speisenden Hochfrequenzspannung erzeugt, wobei über wenigstens eine verbindungsleitung (b) aus der speisenden Hochfrequenzspannung die Spannung zur Speisung der Gleichrichterschaltung (10), die zur Erzeugung der Sperrspannung dient, abgreifbar ist, und wobei der Abgriff der Gleichrichterschaltung (10) gleichstrommäßig entkoppelt ist, und
- die Gleichrichterschaltung (10) so ausgelegt ist, dass sie eine Sperrspannung erzeugt, deren Betrag mindestens dem Spitze-Spitze-Wert der zu schaltenden Hochfrequenzspannung entspricht, und
- die Sperrspannung über dieselbe elektrische Verbindungsleitung (a) geführt wird, über die auch die speisende Hochfrequenzspannung und eine Schließspannung zum Schließen des Hochfrequenzschalters zur Antenne des RFID-Systems geführt wird, wobei die Einspeisung der Sperrspannung in die eletrische Verbindungsleitung (a) hochohmig über einen widerstand (R1) erfolgt, welcher einen widerstandswert zwischen 1 Kiloohm (1 kΩ) und 10 Kiloohm (10 kΩ) aufweist, und
- zu den gleichstrommäßig in Reihe geschalteten PIN-Dioden (V1, V2) jeweils ein Widerstand (R3, R4) parallel geschaltet ist.

2. Elektronische Schaltung nach Anspruch 1, **dadurch gekennzeichnet, dass** die Gleichrichterschaltung (10) zur Erzeugung der Sperrspannung eine Einweggleichrichterschaltung ist.

3. Elektronische Schaltung nach Anspruch 1, **dadurch gekennzeichnet, dass** die Gleichrichterschaltung (10) zur Erzeugung der Sperrspannung eine Spannungsvervielfachungsschaltung ist.

4. Elektronische Schaltung nach Anspruch 1, **dadurch gekennzeichnet, dass** eine Kapazität (C2) zur Erhaltung der Sperrspannung mindestens für die erforderliche Dauer vorgesehen ist.

5. Elektronische Schaltung nach einem der vorherigen Ansprüche, **dadurch gekennzeichnet, dass** eine Entkoppelschaltung (39) vorgesehen ist, die als eine das Entladen der Sperrspannung über die verbindungsleitung (a, f) verhindernde Entkoppelschaltung (39) ausgebildet ist.

6. Elektronische Schaltung nach Anspruch 1, **dadurch gekennzeichnet, dass** die den PIN-Dioden (V1, V2) jeweils parallel geschalteten Widerstände (R3, R4) Werte zwischen 1 Megaohm (1 MΩ) und 10 Megaohm (10 MΩ) aufweisen.

7. Elektronische Schaltung nach Anspruch 4, **dadurch gekennzeichnet, dass** die Kapazität (C2) Werte zwischen 1 Mikrofarad (1 µF) und 10 Mikrofarad (10 µF) aufweist.

## Claims

1. Electronic circuitry for a high-frequency switch for opening an antenna oscillating circuit of an RFID system, wherein the high-frequency switch, composed of at least two PIN diodes, can be opened and closed via d.c. voltages,
**characterised in that**
- a rectifier circuit (10), arranged exterior to the antenna oscillating circuit, generates the reverse voltage to open the high-frequency switch (14) from the power-supplying high-frequency voltage, wherein the voltage to supply power to the rectifier circuit (10), serving to generate the reverse voltage, is able to be tapped off from the power-supplying high-frequency voltage via at least one connecting cable (b), and wherein the tapping of the rectifier circuit (10) is decoupled as regards direct current, and
- the rectifier circuit (10) is designed such that it generates a reverse voltage whose magnitude at least corresponds to the peak-to-peak value of the high-frequency voltage to be connected, and
- the reverse voltage is carried via the same electrical connecting cable (a) via which the power-supplying high-frequency voltage and a closing voltage for closing the high-frequency switch for the antenna of the RFID system are also carried, wherein the feeding of the reverse voltage into the electrical connecting cable (a) takes place in a high-resistance manner via a resistor (R1) with a resistance value between 1 kilo-ohm (1 kΩ) and 10 kilo-ohms (10 kΩ), and
- a respective resistor (R3, R4) is connected in parallel with the PIN diodes (V1, V2) connected in series as regards direct current.

2. Electronic circuitry according to claim 1, **characterised in that** the rectifier circuit (10) for generating the reverse voltage is a half-wave rectifier circuit.

3. Electronic circuitry according to claim 1, **characterised in that** the rectifier circuit (10) for generating the reverse voltage is a voltage multiplication circuit.

4. Electronic circuitry according to claim 1, **characterised in that** a capacitor (C2) to retain the reverse voltage at least for the required duration is provided.

5. Electronic circuitry according to any one of the preceding claims, **characterised in that** a decoupling circuit (39) is provided and is in the form of a decoupling circuit (39) preventing the discharge of the reverse voltage via the connecting cable (a, f).

6. Electronic circuitry according to claim 1, **characterised in that** the resistors (R3, R4) connected in parallel with the respective PIN diodes (V1, V2) have values between 1 megaohm (1 MΩ) and 10 megaohms (10 MΩ).

7. Electronic circuitry according to claim 4, **characterised in that** the capacitor (C2) has values between 1 microfarad (1 µF) and 10 microfarads (10 µF).

## Revendications

1. Circuit électronique pour un commutateur haute fréquence pour l'ouverture d'un circuit oscillant d'antenne d'un système d'identification RF (RFID), dans lequel le commutateur haute fréquence, qui est réalisé sur la base d'au moins deux diodes PIN, peut être ouvert et fermé par des tensions continues,
**caractérisé en ce que**
- un circuit de redressement (10), qui est agencé à l'extérieur du circuit oscillant d'antenne, produit la tension de blocage pour l'ouverture du commutateur haute fréquence (14) à partir de la tension haute fréquence d'alimentation, dans lequel, la tension pour l'alimentation du circuit de redressement (10) servant à produire la tension de blocage peut être prélevée à partir de la tension haute fréquence d'alimentation grâce à au moins une ligne de liaison (b), et dans lequel le prélèvement du circuit de redressement (10) est découplé en ce qui concerne du courant continu, et
- le circuit de redressement (10) est conçu de telle sorte qu'il produit une tension de blocage dont la valeur correspond au moins à la valeur crête-à-crête de la tension haute fréquence à commuter, et
- la tension de blocage est amenée sur la même ligne de liaison électrique (a) que celle sur laquelle une tension haute fréquence d'alimentation ainsi qu'une tension de fermeture pour la fermeture du commutateur haute fréquence est aussi amenée à l'antenne du système RFID, dans lequel l'injection de la tension de blocage dans la ligne de liaison électrique (a) est réalisée à résistance élevée via une résistance (R1) ayant une valeur de résistance entre 1 kOhm (1 kΩ) et 10 kOhm (10 kΩ), et
- une résistance (R3, R4) est branchée en parallèle avec chacune des diodes PIN (V1, V2) connectées en série avec le même sens courant continu.

2. Circuit électronique selon la revendication 1, **caractérisé en ce que** le circuit de redressement (10) est, pour produire la tension de blocage, un circuit redresseur simple alternance.

3. Circuit électronique selon la revendication 1, **caractérisé en ce que** le circuit redresseur (10) est, pour produire la tension de blocage, un circuit multiplicateur de la tension.

4. Circuit électronique selon la revendication 1, **caractérisé en ce qu'**une capacité (C2) est prévue pour le maintien de la tension de blocage au moins pendant la durée nécessaire.

5. Circuit électronique selon l'une des revendications précédentes, **caractérisé en ce que** il est prévu un circuit de découplage (39) qui est réalisé sous forme d'un circuit de découplage (39) qui empêche la décharge de la tension de blocage via la ligne de liaison (a, f).

6. Circuit électronique selon la revendication 1, **caractérisé en ce que** les résistances (R3, R4) branchées respectivement en parallèle avec les diodes PIN (V1, V2) présentent des valeurs entre 1 MégaOhm (1 MΩ) et 10 MégaOhm (10 MΩ).

7. Circuit électronique selon la revendication 4, **caractérisé en ce que** la capacité (C2) présente des valeurs entre 1 Microfarad (1 µF) et 10 Microfarad (10 µF).
